# EUROPEAN PATENT APPLICATION

(11) **EP 2 289 845 A1**
(43) Date of publication of application: **02.03.2011**
(21) Application number: 09305797.4
(22) Date of filing: 28.08.2009
(51) Int. Cl.: B81C 3/00, B81C 1/00, B01J 19/00, C03B 23/203

(54) **Layered sintered microfluidic devices with controlled compression during sintering and associated methods**

(71) Applicant: Corning Incorporated, Corning NY 14831 (US)
(72) Inventor: Friske, Mark, 77133 Fericy (FR); Lereboullet, Jean-Pierre, 77590, Bois le Roi (FR); Lobet, Olivier, 91450 Mennecy (FR); Nedelec, Yann, 77210 Avon (FR); Bruneaux, Jean-François, 77560 Beauchery St Martin (FR)
(74) Representative: Le Roux, Martine

(57) **Abstract**

Embodiments are directed a method for reducing and/or controlling compression of stacked layers (11, 12, 13, 14) in a microfluidic device (10), wherein the method comprises stacking at least two layers (11, 12, 13, 14), wherein at least one of the stacked layers (11, 12, 13, 14) comprises a microstructure (30). The microstructure (30) comprises a fluid passage (33), a plurality of walls (32) configured to define a spacing Δ₁ between layers (11, 12, 13, 14), and a plurality of uniformly spaced pneumatic struts (40) wherein the pneumatic struts (40) define sealed containers comprising entrapped gas. The method further comprises the step of sintering the stacked layers (11, 12, 13, 14), wherein the sintering pressurizes the entrapped gas inside the pneumatic struts (40) to oppose compression of the walls (32) and compression of the spacing Δ₁ between stacked layers (11, 12, 13, 14).

## Description

The present disclosure is generally directed to microfluidic devices, and, more specifically, to microfluidic devices and associated methods useful for controlling sintering in microfluidic devices having layers sealed or bonded together by sintering.

Microfluidic devices, which may also be referred to as microstructured reactors, microchannel reactors, microcircuit reactors, or microreactors, are devices in which a fluid or fluid-borne material can be confined and subjected to processing. The processing may involve physical, chemical, or biological processes or combinations of these, and may include the analysis of such processes. The processing may optionally be executed as part of a manufacturing process. Heat exchange may also be provided between the confined fluid and an associated heat exchange fluid. In any case, the characteristic smallest cross-sectional dimensions of the confined spaces of a microfluidic device, as that term is used herein, are on the order of from 0.1 to 5 mm, desirably from 0.5 to 2 mm. Microchannels are the most typical form of such confinement and the microfluidic device is usually a continuous flow device or continuous flow reactor. The internal dimensions of the microchannels provide considerable improvement in mass and heat transfer rates over more traditional processing devices and methods. Microfluidic devices that employ microchannels offer many advantages over conventional scale reactors, including significant improvements in energy efficiency, reaction speed, reaction yield, safety, reliability, scalability, etc.

The present invention relates to a method, for reducing and/or controlling compression of layers in a layered microfluidic device, as defined in the following description and claims 1 to 14, and a microfluidic device as defined in the following description and in claim 15. The content of claims 1 to 15 is incorporated herewith by reference.
According to one aspect of the present disclosure, a method for reducing, and/or controlling compression of layers of a microfluidic device during sintering of the device is provided. The method comprises a step of stacking at least two layers, wherein at least one of the stacked layers comprises a microstructure. The microstructure comprises a fluid passage, a plurality of walls configured to define a spacing Δ₁ between layers, and to define a plurality of spaced pneumatic struts, wherein the pneumatic struts comprise closed containers having entrapped gas. The method further comprises the step of sintering the stacked layers, wherein the sintering pressurizes entrapped gas inside the pneumatic struts to oppose compression of the walls and compression of the spacing Δ₁ between the stacked layers.

According to another aspect of the present disclosure, a microfluidic device is provided comprising at least two layers, each layer comprising a microstructure, wherein the microstructure comprises: a fluid passage and a plurality of walls configured to define a spacing Δ1 between the layers and to define a plurality of uniformly spaced pneumatic struts, wherein the pneumatic struts comprise containers having entrapped gas.

These and additional features provided by the embodiments of the present disclosure will be more fully understood in view of the following detailed description, in conjunction with the drawings.

The following detailed description of specific embodiments of the present disclosure can be best understood when read in conjunction with the following drawings, where like structure is indicated with like reference numerals and in which:

FIG. 1A is schematic cross-sectional view of one embodiment of a microfluidic device 10 supported on a substrate 8 prior to sintering according to one or more embodiments of the present disclosure;

FIG. 1B is a schematic cross-sectional view of another embodiment of a microfluidic device 10 supported on a substrate 8 prior to sintering according to one or more embodiments of the present disclosure;

FIG. 2A is top view of a microstructure 30 which depicts the fluid passages 33 and pneumatic strut embodiments 41, 42, 43 according to one or more embodiments of the present disclosure;

FIG. 2B is an exploded view of the pneumatic strut embodiments 41, 42, 43 shown in FIG. 2A according to one or more embodiments of the present disclosure;

FIG. 2C is a schematic view of ring shaped pneumatic struts 46 arranged in a homogeneous matrix pattern according to one or more embodiments of the present disclosure;

FIG. 3 is a schematic view of a microfluidic device 10 with pneumatic struts 40 after sintering according to one or more embodiments of the present disclosure; and

FIG. 4 is a schematic view of a microfluidic device 10 without pneumatic struts after sintering according to one or more embodiments of the present disclosure.

The embodiments set forth in the drawings are illustrative in nature and are not to scale and are not intended to be limiting of the invention defined by the claims. Moreover, individual features of the drawings and the claims will be more fully apparent and understood in view of the detailed description.

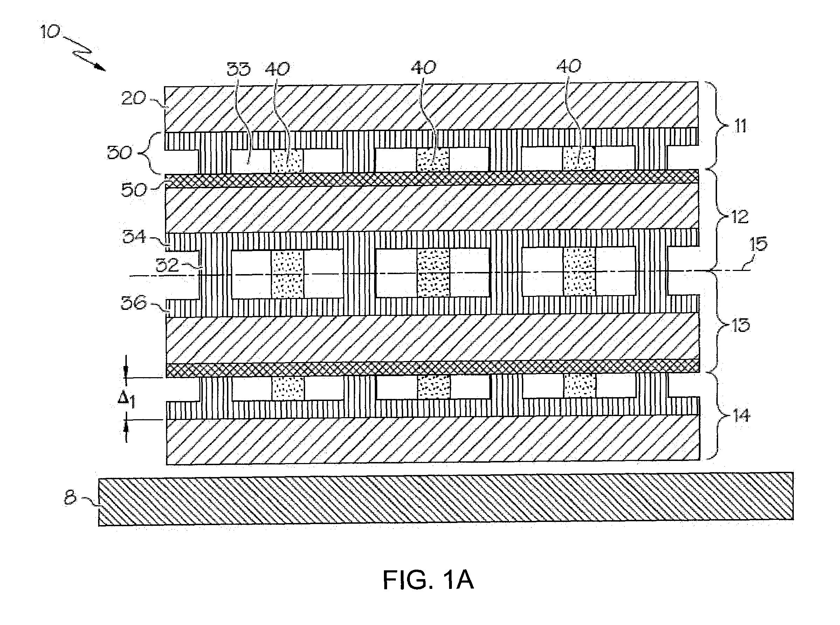

Referring to FIG. 1A, one embodiment of a microfluidic device 10 comprising multiple layers (for example, layers 11, 12, 13, 14) is shown in schematic cross-section. While all figures herein depict four layers, it is contemplated that more or less layers may be used in the microfluidic devices 10. In fact, one of the benefits as described below is the increased flexibility in producing stacks with more than 4 layers. As shown in the embodiment of FIG. 1A, at least one of the layers (11, 12, 13, or 14) in the microfluidic device 10 comprises a microstructure 30. As used herein, "microstructure" merely denotes a structured component in a microfluidic device 10, and should not be construed to limit the size of microstructure.

To produce the stacked microfluidic device 10 of FIG. 1A, the layers 11, 12, 13, 14 must first be prepared. Depending on the desired application for the layers 11, 12, 13, 14 and positioning in the microfluidic device 10, the layers 11, 12, 13, 14 may include various sublayers. Referring to FIG. 1A, layer 14 may comprise a sinterable microstructure 30 applied onto a substrate 20. In one embodiment, the sinterable microstructure 30 is applied as a paste comprising glass particles (glass frit) and a binder. Suitable materials for the substrate 20 and/or the microstructure 30 may include, but are not limited to, fused silica glass, fused quartz, glass ceramics, titanium silicate glass, borosilicate glass, mixtures thereof, or any other suitable glass material familiar to one of ordinary skill in the art, as well as ceramic materials, such as alumina and silicon carbide, and other high-temperature-resistant materials, such as silicon. The borosilicate glass may be Pyrex® 7761 (potash borosilicate crushed/powdered glass) produced by Coming Inc. The binder may include any suitable binder, for example, ethyl cellulose. In further embodiments, solvents (e.g., α terpineol) may be added to assist in the application of the microstructure 30 onto the substrate 20. It is also contemplated as a variation on the embodiment of FIG. 1A that the microstructure 30 may be a solid glass plate adhered to a glass substrate using suitable adhesives, such as glues, tapes, resins, etc. Microstructure 30 may also take the form of glass hot-pressed (molded) onto the substrate, in which case microstructure 30 would have no binder and not require sintering for solidification, only for bonding or sealing. Substrate materials may also be extended to certain high-temperature, low CTE metals and metal alloys, if desired.

In addition to the microstructure 30 and the substrate 20, at least one of the layers 11, 12, 13, 14 may also include a sinterable flat layer 50 molded or otherwise formed on a surface of the substrate 20 as shown in FIG. 1A. As used herein, "flat" denotes that the layer is substantially planar; however, the flat layer still may encompass raised or recessed regions as well as curvatures in the surface. Like the sinterable microstructure 30, the sinterable flat layer 50 may be applied as a glass paste comprising glass particles and a binder. The different sublayers of the layers 11, 12, 13, 14, i.e., the substrate 20, the microstructure 30, and/or the flat layer 50 may comprise the same material, desirably a glass material, to increase the adhesion of the layers 11, 12, 13, 14 and sublayers 20, 30, 50 after heat treatment (for example, debinding or sintering as described below). That being said, it is also contemplated that the sublayers 20, 30, 50 may comprise different materials as listed above.

Referring again to FIG. 1A, before stacking of the layers 11, 12, 13, 14, the layers may undergo a partial debinding or "pre-sintering" step to remove a portion of the binder from each microstructure 30 or flat layer 50, or both, wherein such partial debinding involves heating to a temperature and for a time sufficient to partially evaporate the binder material prior to sintering. This partial debinding process is preferably conducted in a temperature range of from about 200 to about 600°C. The amount of binder remaining in the layers may be increased or decreased as needed by adjusting the time or temperature of the partial debinding. After partial debinding, the layers 11, 12, 13, 14 are stacked, and desirably pressed together with a weight or other source of compressing force to be ready for sintering.

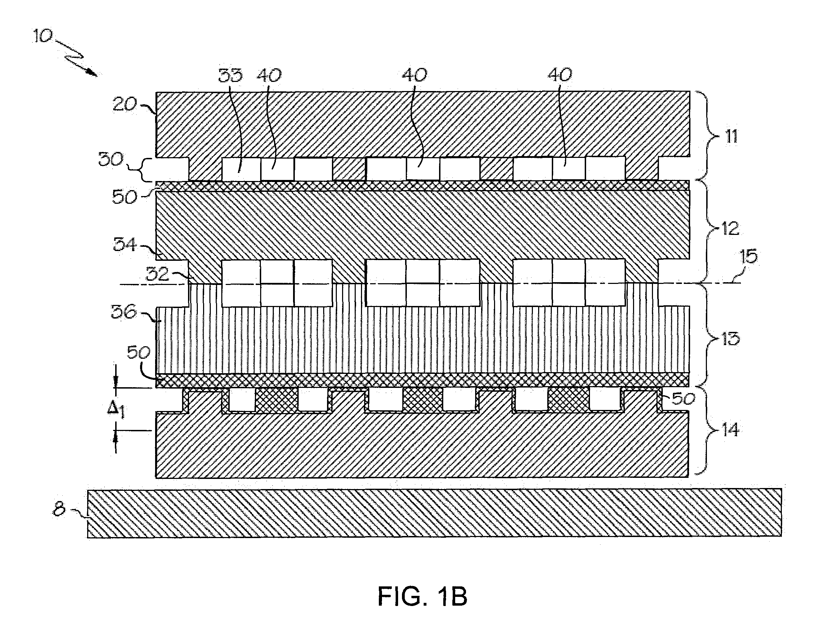

Referring to FIG. 1B, another embodiment of a microfluidic device 10 comprising multiple layers 11, 12, 13, 14 is shown in schematic cross-section. As shown in the embodiment of FIG. 1B, at least one of the layers (11, 12, 13, or 14) in the microfluidic device 10 includes a microstructure 30. Microstructure 30 of the embodiment of FIG. 1B differs from that of FIG. 1A in that microstructure 30 of FIG. 1B is molded of formed as a single piece with the underlying substrate, desirably by a process such as the hot pressing process developed by the present inventors and/or their colleagues and disclosed and described, for example, in PCT Publication No. WO2008106160. This process may also be used to form the microstructure 30 onto a substrate in one of the alternative versions of the embodiment of FIG. 1A mentioned above. As alternatives shown in the various layers 11, 12, 13, 14 of FIG. 1B, the layers 11, 12, 13, 14 may include additional layers of sinterable material 50 such as glass frit layers 50 to aid in sealing, on one or both facing faces, or optionally may include no intermediate material between the bulk material of the layers 11, 12, 13, 14.

After stacking, the microfluidic device 10 of FIG. 1A or 1B is sintered to seal or bond the layers 11, 12, 13, 14 together. As used herein, sintering refers to high temperature heat treatment at a temperature sufficient to bond the layers 11, 12, 13, 14, and the sublayers 20, 30, and/or 50 therewith. The sintering temperature is desirably between about 800 to about 1500°C; however, various temperature ranges are contemplated depending on the material used in the microfluidic device 10. In the case of the embodiment of FIG. 1A, when binder-containing microstructure 30 is used, a final debinding takes place before or during the first part of sintering that evaporates substantially all of the binder from the sinterable material, and the remaining sinterable particles are solidified into a final structure. In the case of the embodiment of FIG. 1A, when solid molded glass microstructure 30 is used, or in the embodiment of FIG. 1B, the layers 11, 12, 13, 14 (except for any sinterable layer 50) are already solid, so the principle purpose of sintering is simply to bond or seal the layers together. As shown in both FIGS. 1A and 1B, the layers 11, 12, 13, 14 may be arranged on a support structure 8 during sintering. The structure 8 may be formed of alumina or other suitable material.

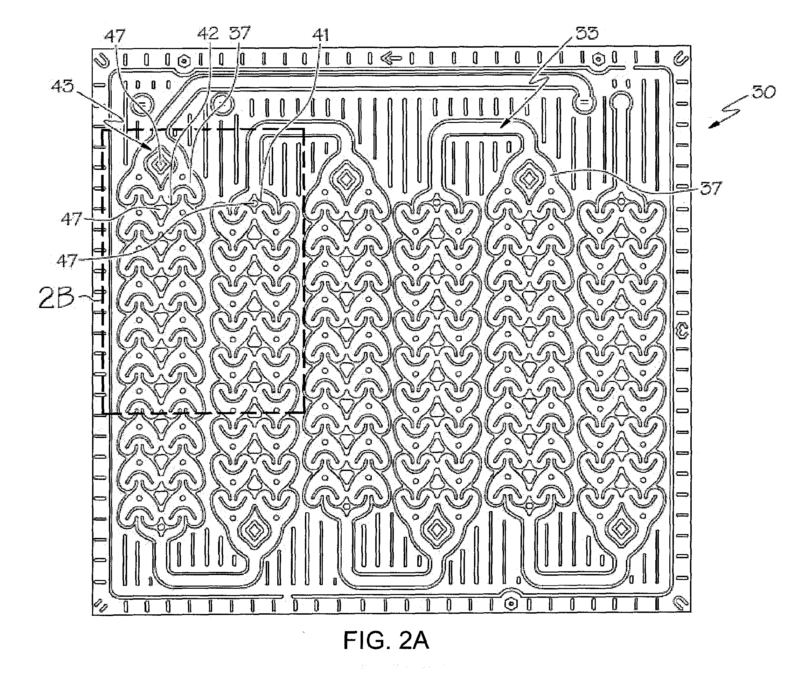

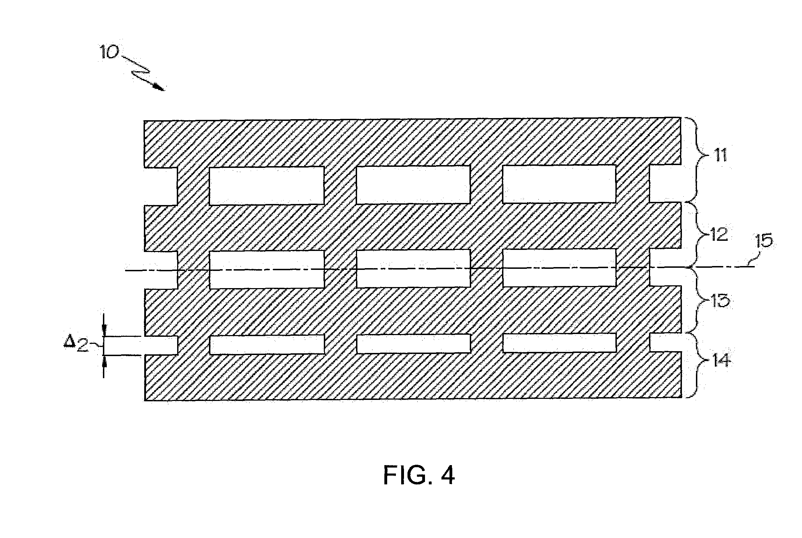

Referring to FIG. 4, undesirable compression of the layers 11, 12, 13, 14 of the microfluidic device 10 may occur during sintering. One instance of this is shown in FIG. 4, in which the weight of the layers 11, 12, 13 has caused compression or slumping or sagging of layer 13 toward layer 14, as demonstrated by the decreased distance Δ₂ between layers 13 and 14, relative to the spacing between the other layers, designed, in this instance, to be the same as that between layers 13 and 14. Due to this compression, the cross section and total volume of the channels 37 of a fluid passage 33 as seen in plan view in FIGS. 2A-2B may be undesirably reduced, thereby affecting fluid processing in the resulting microfluidic device 10. The microstructure 30 disclosed herein is designed to address the problem of undesirable compression or sagging or slumping in the microfluidic device 10 during sintering such as that shown in FIG. 4 or any other forms.

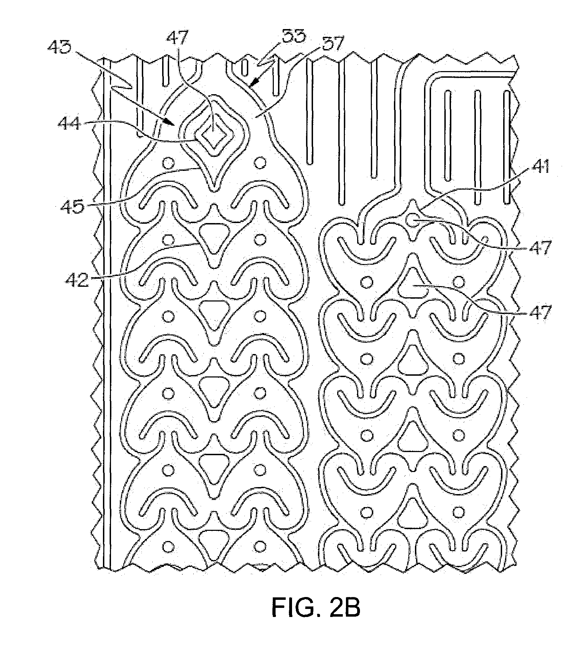

Referring to FIGS. 1A-1B and 2A-2C, the microstructure 30 may comprise the fluid passage 33, which is used for fluid reaction or processing. As shown in FIGS. 2A and 2B, the fluid passage 33 may comprise multiple channels 37 and a serpentine path. It is contemplated to use various alternative flow patterns and designs depending on factors such as fluid residence time, fluid mixing, etc. The fluid passage 33 may be at least partially disposed in the spacing Δ₁ between layers 11, 12, 13, 14. As will be described below, the fluid passage 33 is typically open or unsealed during the sintering processing to minimize or prevent pressure buildup inside of the fluid passage 33. Consequently, the fluid passage 33 may have substantially the same pressure as the furnace, within which the sintering step is conducted.

Referring again to FIGS. 1A and 1B the microstructure 30 may also comprise a plurality of walls 32 configured to support the layers and define a spacing Δ₁ between layers 11, 12, 13, 14. As shown in the embodiment FIG. 1A, the microstructure 30 may comprise a flat portion 34 with walls 32 extending therefrom, or as in FIG. 1B, the microstructure 30, including walls 32, may be integral with the larger structure of the layer 11, 12, 13, 14. In addition to maintaining spacing between layers 11, 12, 13, 14 in the microfluidic device 10, the walls 32 may assist in aligning the layers in the device. The walls 32 may be positioned at various locations on the microstructure 30 as desired to form fluid passages 33. As shown in FIG. 4, the walls 32 may be compressed during sintering due to the collective weight of the layers. The walls 32 may be present within the fluid passage 33, wherein the walls may act as channel 37 walls of the fluid passage. Alternatively, the walls 32 may be structures disposed separately from the fluid passage 33.

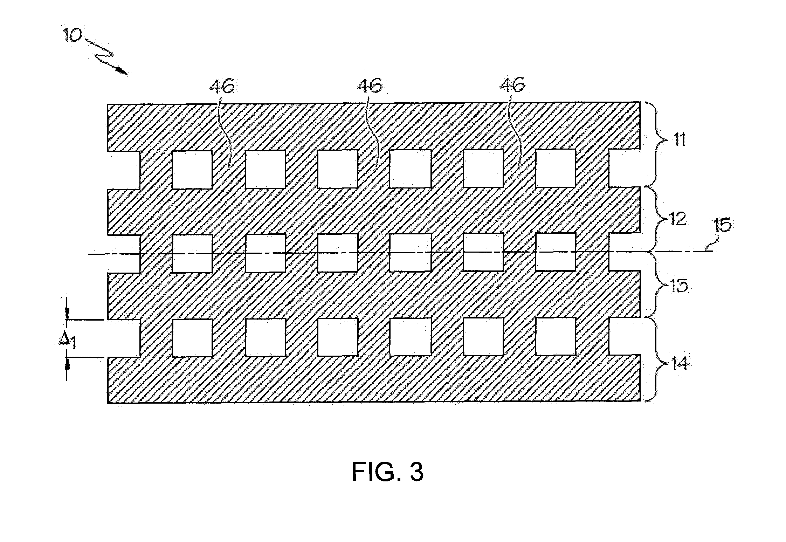

To reduce or control this compression caused by the weight of the layers, the walls 32 of microstructure 30, as shown in FIGS. 1A-1B and 2A-2C, may also define a plurality of uniformly spaced pneumatic struts 40, wherein the pneumatic struts 40 comprise containers having entrapped gas. During sintering (or other contemplated heat treatment steps), the entrapped gas inside the pneumatic struts 40 are pressurized. The pressurization delivers a force which acts against a gravitational or other force tending to compress at least one of the layers 11, 12, 13, 14 and thereby opposes compression of the walls 32. Referring to FIG. 3, opposing compression of the walls reduces and/or controls the compression of the spacing Δ₁ between layers 13, 14 during sintering. While the embodiment of FIG. 3 depicts reducing the compression between layers 13 and 14 during sintering, it is understood that the pneumatic struts 40 may be present in any of the layers 11, 12, 13, 14 to prevent, reduce, or control compression in the layer microfluidic device 10. In essence, the pneumatic struts 40 reduce and/or control the slumping or sagging as described above and shown in FIG. 4.

It is contemplated that the pneumatic struts 40 may at least partially expand in response to pressurization of the entrapped air; however, it is not necessary for the pneumatic struts to expand. In some cases, when the volume of the pneumatic strut expands excessively, there is a danger of rupturing. Consequently, it is desirable that the pressurization of the entrapped air increase the rigidity of the pneumatic strut 40 while minimally expanding or not expanding the volume of the pneumatic strut 40.

In contrast to the pressurization of the sealed pneumatic struts 40 during sintering, the fluid passages 33 are open during sintering, thus there is minimal or no pressure buildup inside the fluid passages 33 during sintering. As a result, there is a pressure difference ΔP during sintering between the fluid passages 33 and the pneumatic struts 40. The present inventors have recognized that this pressure difference ΔP must be managed to ensure proper performance of the microfluidic device 10. If the ΔP is too large, and the pneumatic strut 40 is disposed within a fluid passage 33 (e.g., the nested pneumatic strut 43 disposed adjacent channel 37 of fluid passage 33 as shown in FIGS. 2A and 2B), excessive deformation of the pneumatic strut 40 may provide undesirable stresses to the fluid passage 33. For example, if the pneumatic struts 40 expand significantly, bends, bulges, cracks, etc may be formed in an adjacent channel 37 of a fluid passage 33.

Consequently, the pressure difference ΔP must be controlled during sintering. To control the pressure difference ΔP, the total enclosed volume of a pneumatic strut, the sintering time and temperature, the materials of the microstructure (including the sinterable and other materials therein), etc. may all be optimized to ensure that the pressure buildup is sufficient to reduce and/or control layer compression, but not so great as to rupture or excessively deform the pneumatic strut 40. Where sinterable walls 32 are used, the amount of binder remaining at the start of the final debinding/sintering may also be adjusted, as out-gassing of binder can contribute to the internal pressure of the struts. Additionally, it is also desirable to optimize the rigidity and/or viscosity of the pneumatic strut 40. If the viscosity is too low, the expansion of the strut 40 may bend the walls of adjacent fluid passages 33 so as to make them convex in some degree. The resulting sharp-angled corners (i.e., where a convex wall intersects the floor or ceiling of a fluid passage) are areas of stress concentration. When a passage is pressurized, stress in the passage walls is generally concentrated at the corners and is highly concentrated by sharp or acute-angled corners, resulting in lower resistance to pressure.

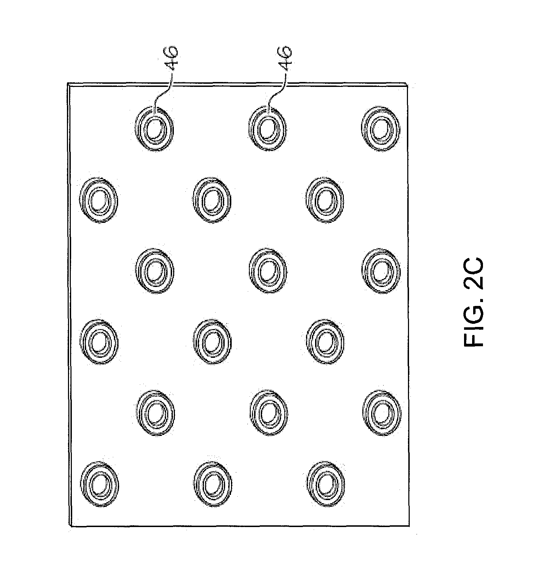

Numerous arrangements for uniformly spaced pneumatic struts 40 are contemplated herein. As used herein, "uniformly" means that the pneumatic struts are disposed on the microstructure such that the collective compression resistant force delivered by the pneumatic struts is distributed substantially evenly across the microstructure. The pneumatic struts 40 may be disposed near the edges, and/or corners, and the pneumatic struts 40 may also be disposed near the center of the microstructure 30. For example, as shown in FIG 2C, the shown pneumatic strut embodiments 46, which are ring shaped sealed containers, may be disposed in a homogeneous matrix pattern. Alternatively as shown in FIGS. 2A and 2B, the pneumatic strut embodiments 41, 42, and 43 may also be disposed within fluid passage 33.

Referring to FIGS 1A-1B and 2A-2C, the pneumatic struts 40 may define various shapes. For example, the pneumatic struts may comprise a plurality of rings 46 as shown in FIG. 2C. Due to the hollow opening 47, the ring shape pneumatic strut 46 is more compact and pressure resistant, thus the strut 46 minimizes the volume expansion or the likelihood of rupturing of the strut 46. Similarly, the pneumatic strut embodiments 41, 42, and 43 all include hollow openings 47 to make the structures more rigid and compact. While pneumatic strut embodiments 41, 42, and 46 depict single container pneumatic struts, it is also possible to have struts comprised of multiple sealed containers. For example as shown in FIGS. 2A and 2B, the pneumatic struts may comprise nested structures 43, wherein the nested structure 43 includes at least two coaxially disposed pneumatic struts 44, 45. Other structures and arrangements for the pneumatic struts are contemplated herein.

Without being bound by theory, the pneumatic struts 40 provide more flexibility in designing multilayer microfluidic devices. As the number of layers is increased, the increased weight of the layers, or the increased forces that need to be applied to seal a large number of layers, may cause compression of the walls 32 and thereby the slumping or sagging of layers one instance of which is shown in FIG. 4. This sagging effect limits the number of layers which may be reliably included in a microfluidic device of the type discussed. However, the pneumatic struts 40 counteract at least in part the weight of the layers or other force and thereby provide the capability to add additional layers to a microfluidic device.

The devices disclosed herein and/or produced by the methods disclosed herein are generally useful in performing any process that involves mixing, separation, extraction, crystallization, precipitation, or otherwise processing fluids or mixtures of fluids, including multiphase mixtures of fluids-and including fluids or mixtures of fluids including multiphase mixtures of fluids that also contain solids-within a microstructure. The processing may include a physical process, a chemical reaction defined as a process that results in the interconversion of organic, inorganic, or both organic and inorganic species, a biochemical process, or any other form of processing. The following non-limiting list of reactions may be performed with the disclosed methods and/or devices: oxidation; reduction; substitution; elimination; addition; ligand exchange; metal exchange; and ion exchange. More specifically, reactions of any of the following non-limiting list may be performed with the disclosed methods and/or devices: polymerization; alkylation; dealkylation; nitration; peroxidation; sulfoxidation; epoxidation; ammoxidation; hydrogenation; dehydrogenation; organometallic reactions; precious metal chemistry/ homogeneous catalyst reactions; carbonylation; thiocarbonylation; alkoxylation; halogenation; dehydrohalogenation; dehalogenation; hydroformylation; carboxylation; decarboxylation; amination; arylation; peptide coupling; aldol condensation; cyclocondensation; dehydrocyclization; esterification; amidation; heterocyclic synthesis; dehydration; alcoholysis; hydrolysis; ammonolysis; etherification; enzymatic synthesis; ketalization; saponification; isomerisation; quaternization; formylation; phase transfer reactions; silylations; nitrile synthesis; phosphorylation; ozonolysis; azide chemistry; metathesis; hydrosilylation; coupling reactions; and enzymatic reactions.

For the purposes of describing and defining the present invention it is noted that the term "approximately", "about", "substantially" or the like are utilized herein to represent the inherent degree of uncertainty that may be attributed to any quantitative comparison, value, measurement, or other representation. These terms are also utilized herein to represent the degree by which a quantitative representation may vary from a stated reference without resulting in a change in the basic function of the subject matter at issue. Moreover, although the term "at least" is utilized to define several components of the present invention, components which do not utilize this term are not limited to a single element.

To the extent that any meaning or definition of a term in this written document conflicts with any meaning or definition of the term in a document incorporated by reference, the meaning or definition assigned to the term in this written document shall govern.

Having described the claimed invention in detail and by reference to specific embodiments thereof, it will be apparent that modifications and variations are possible without departing from the scope defined in the appended claims. More specifically, although some aspects are identified herein as preferred or particularly advantageous, it is contemplated that the present claims are not necessarily limited to these preferred aspects.

## Claims

1. A method for reducing, and/or controlling compression of layers (11, 12, 13, 14) in a layered microfluidic device (10) comprising:
stacking at least two layers (11, 12, 13, 14), wherein at least one of the stacked layers (11, 12, 13, 14) comprises a microstructure (30), wherein the microstructure (30) comprises:
a fluid passage (33),
a plurality of walls (32) configured to define a spacing Δ₁ between layers (11, 12, 13, 14) and to define a plurality of pneumatic struts (41, 42, 43, 46), wherein the pneumatic struts (41, 42, 43, 46) define sealed containers comprising entrapped gas; and
sintering the stacked layers (11, 12, 13, 14) wherein the sintering pressurizes the entrapped gas inside the pneumatic struts (41, 42, 43, 46) so as to oppose compression of the walls (32) and compression of the spacing Δ₁ between stacked layers (11, 12, 13, 14).

2. The method according to claim 1 wherein the fluid passage (33) is at least partially disposed in the spacing Δ₁ between stacked layers (11, 12, 13, 14).

3. The method according to either of claims 1 and 2 wherein the walls (32) comprised sinterable walls (32).

4. The method according to any of claims 1-3 wherein the pneumatic struts (40, 41, 42, 43, 46) are arranged in a homogenous matrix pattern.

5. The method according to any of claims 1-4 wherein the pneumatic struts (40, 41, 42, 43, 46) are disposed within or adjacent the fluid passage (33).

6. The method according to any of claims 1-5 wherein the fluid passage (33) comprises a plurality of channels (37).

7. The method according to any of claims 1-6 wherein the pneumatic struts (40) comprise a ring shape (46).

8. The method according to any of claims 1-7 wherein the pneumatic struts (40) comprise at least one nested structure (43).

9. The method according to claim 8 wherein the nested structure (43) includes at least two coaxial pneumatic struts (44, 45).

10. The method according to any of claims 1-9 further comprising preparing at least one of the layers (11, 12, 13, 14) by applying the microstructure (30) onto a substrate (20) prior to stacking, wherein the microstructure (30) is applied as a paste comprising glass particles and a binder.

11. The method according to claim 10 wherein at least one of the layers (11, 12, 13, 14) comprises a flat layer (50) molded on a surface of the substrate (20).

12. The method according to any of claims 10 and 11 further comprising heating the microfluidic device (10) to partially evaporate the binder material prior to sintering.

13. The method according to any of claims 1-9 further comprising preparing at least one of the layers (11, 12, 13, 14) by applying the microstructure (30) onto a substrate (20) prior to stacking, wherein the microstructure (30) is applied by a hot glass pressing process.

14. The method according to any of claims 1-9 further comprising preparing at least one of the layers (11, 12, 13, 14) by forming the microstructure (30) as one integrated piece with the rest of respect layer (11,12, 13, or 14) wherein the microstructure (30) is formed by a hot glass pressing process.

15. A microfluidic device (10) comprising at least two layers (11, 12, 13, 14), each layer (11, 12, 13, 14) comprising a microstructure (30), wherein the microstructure (30) comprises:
a fluid passage (33); and
a plurality of walls (32) configured to define a spacing Δ₁ between layers (11, 12, 13, 14) and to define a plurality of uniformly spaced pneumatic struts (40), wherein the pneumatic struts (40) comprise sealed containers having entrapped gas.
